# EUROPEAN PATENT APPLICATION

(11) **EP 4 086 941 A1**
(43) Date of publication of application: **09.11.2022**
(21) Application number: 20907611.6
(22) Date of filing: 11.12.2020
(51) Int. Cl.: H01L 21/329, H01L 21/02, H01L 21/205, H01L 29/06, H01L 29/872

(54) **METHOD FOR PRODUCING SEMICONDUCTOR ELEMENT, AND SEMICONDUCTOR DEVICE**

(30) Priority: 26.12.2019 JP 2019237531
(71) Applicant: Kyocera Corporation, Kyoto-shi Kyoto 612-8501 (JP)
(72) Inventor: AZUMA, Katsunori, Kyoto-shi, Kyoto 612-8501 (JP); HIRAYAMA, Tomohisa, Kyoto-shi, Kyoto 612-8501 (JP)
(74) Representative: Viering, Jentschura & Partner mbB Patent- und Rechtsanwälte
(86) International application number: PCT/JP2020/046353
(87) International publication number: WO 2021/131808

(57) **Abstract**

A manufacturing method for a semiconductor element includes a step of forming a mask 21 partly having an opening and configured to cover a surface of a base substrate 11, and a step of forming a semiconductor layer 31 containing a predetermined semiconductor material by inducing epitaxial growth along the mask 21 from the surface of the base substrate 11 exposed from an opening 22. A surface 21a on the side closer to the semiconductor layer 31 in the mask 21 is formed of an amorphous first material that does not contain an element to serve as a donor or an acceptor in the predetermined semiconductor material.

## Description

### Technical Field

The present application relates to a manufacturing method for a semiconductor element, and a semiconductor device.

### Background Art

A manufacturing method for a semiconductor element in which a GaN-based semiconductor is fabricated by an epitaxial lateral overgrowth (ELO) technique using a mask formed of SiO₂, is described in Patent Document 1.

### Citation List

### Patent Literature

Patent Document 1: JP 4638958 B

### Summary

### Technical Problem

In a case where a GaN-based semiconductor is fabricated by the epitaxial lateral overgrowth (ELO) technique using a growth mask containing Si such as SiO₂, auto-doping may occur in which Si in the growth mask is incorporated into a crystal. Si serves as an n-type doping material in the GaN-based semiconductor, and therefore it is difficult to achieve a low doping concentration in the order of not greater than 10¹⁶/cm³.

### Solution to Problem

A manufacturing method for a semiconductor element according to an aspect includes a step of forming a mask partly having an opening and configured to cover a surface of a substrate, and a step of forming a semiconductor layer containing a predetermined semiconductor material by inducing epitaxial growth along the mask from the surface of the substrate exposed from the opening, wherein a surface on a side closer to the semiconductor layer in the mask is formed of an amorphous first material that does not contain an element to serve as a donor or an acceptor in the predetermined semiconductor material.

A semiconductor device according to an aspect includes: a plurality of semiconductor elements each including a semiconductor layer containing a predetermined semiconductor material, and a first electrode disposed on one surface of the semiconductor layer; and a support substrate configured to support the one surface of the semiconductor layer of each of the plurality of semiconductor elements, wherein, in the semiconductor layer, there are laminated an n⁻ GaN layer located on the other surface and an n⁺ GaN layer located on the one surface.

### Advantageous Effects of Invention

According to an aspect, it is possible to achieve a low doping concentration on the order of not greater than 10¹⁶/cm³.

### Brief Description of Drawings

FIG. 1 is a cross-sectional view for describing a manufacturing method for a semiconductor element according to a first embodiment.
FIG. 2 is a schematic diagram for describing a semiconductor device according to the first embodiment.
FIG. 3 is a flowchart for describing a manufacturing method for a semiconductor element according to the first embodiment.
FIG. 4 includes cross-sectional views for describing a manufacturing method for a semiconductor element according to the first embodiment.
FIG. 5 is a flowchart for describing a manufacturing method for a semiconductor device according to the first embodiment.
FIG. 6 includes cross-sectional views for describing a manufacturing method for a semiconductor device according to the first embodiment.
FIG. 7 is a cross-sectional view for describing a manufacturing method for a semiconductor element according to a second embodiment.
FIG. 8 is a flowchart for describing a manufacturing method for a semiconductor element according to a third embodiment.
FIG. 9 is a flowchart for describing a manufacturing method for a semiconductor element according to a fourth embodiment.
FIG. 10 is a cross-sectional view for describing a manufacturing method for a semiconductor element according to a fifth embodiment.

### Description of Embodiments

A detailed description of an embodiment according to the present application is given while referencing the drawings. In the following description, similar constituent elements may be assigned the same reference signs. Redundant descriptions may be omitted.

### First Embodiment

A semiconductor element 1, a semiconductor device 2, and a manufacturing method for the semiconductor element 1 according to an embodiment will be described.

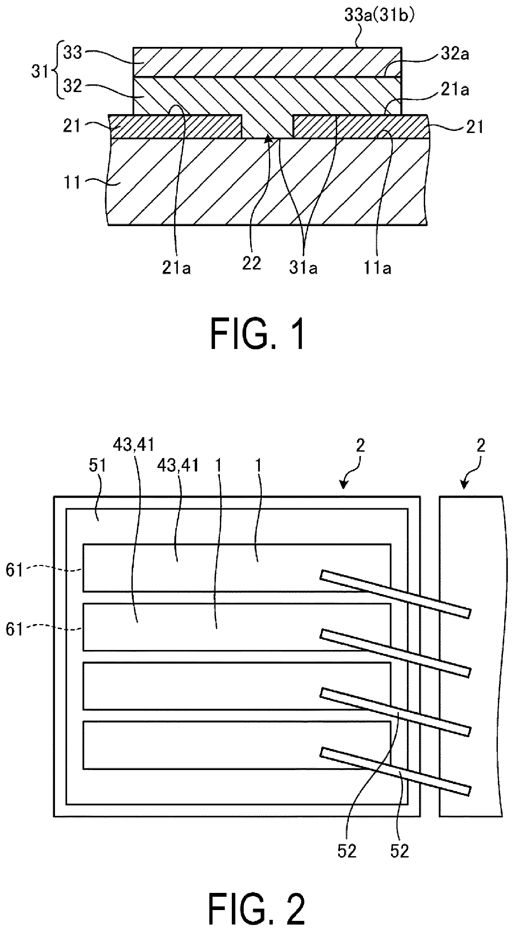

FIG. 1 is a cross-sectional view for describing a manufacturing method for a semiconductor element according to a first embodiment. FIG. 2 is a schematic diagram for describing a semiconductor device according to the first embodiment. A plurality of the semiconductor elements 1 are connected in parallel or in series to form the semiconductor device 2. In the present embodiment, the semiconductor device 2 is a power semiconductor device, for example, such as a Schottky barrier diode (SBD), a metal oxide semiconductor field effect transistor (MOSFET) or the like.

In a manufacturing process, a mask 21 is formed on a surface 11a of a base substrate (substrate) 11 and a semiconductor layer 31 is formed on a surface 21a of the mask 21 in the semiconductor element 1. The semiconductor layer 31 includes an n⁻ GaN layer 32 and an n⁺ GaN layer 33. The semiconductor element 1 includes an ohmic electrode (first electrode) 61 disposed on a side of one surface 31b of the semiconductor layer 31 and a Schottky electrode (second electrode) 41 disposed on the other surface 31a of the semiconductor layer 31. The donor density of the n⁻ GaN layer 32 is, for example, on the order of not greater than 10¹⁷. The donor density of the n⁺ GaN layer 33 is, for example, on the order of not less than 10¹⁸.

The base substrate 11 is a substrate formed of a nitride semiconductor. The base substrate 11 is, for example, a C-plane gallium nitride (GaN) substrate obtained by being cut out from a GaN single crystal ingot. The base substrate 11 is, for example, a C-plane sapphire substrate. The base substrate 11 may be a substrate in which a semiconductor layer such as a GaN layer is grown in a (0001) plane orientation, on a C-plane sapphire substrate or on a (111) plane orientation Si substrate, for example. In the present embodiment, the base substrate 11 is described as being formed with GaN of a C-plane sapphire. The base substrate 11 is peeled from the semiconductor layer 31 in the manufacturing process. The peeled base substrate 11 may be reused in the manufacturing process of other semiconductor elements 1.

The mask 21 is disposed covering the surface 11a of the base substrate 11 in a state where part of the mask 21 is opened. In the present embodiment, the mask 21 includes a plurality of openings 22 each having a strip shape.

The surface 21a on the side closer to the semiconductor layer 31 in the mask 21 is formed of an amorphous first material that does not contain an element to serve as a donor or an acceptor in a predetermined semiconductor material. The predetermined semiconductor material refers to a material of the semiconductor layer 31, and is, for example, GaN. The first material is, for example, aluminum oxide (AlOx) as a material containing an element that does not serve as a donor. In the present embodiment, the mask 21 is described as being formed with AlOx. In the present embodiment, all the peripheral surfaces of the mask 21 including the surface 21a are formed with AlOx. When the predetermined semiconductor material is GaN, an element to serve as a donor is a group 14 element. When the predetermined semiconductor material is GaN, an element to serve as an acceptor is a group 12 element.

The mask 21 is formed as follows: an AlOx film is film-formed on the surface 11a of the base substrate 11, and thereafter openings are partly provided by patterning. A technique of film-forming the AlOx film is, for example, atomic layer deposition (ALD) or sputtering. A technique of the patterning is, for example, photolithography and etching using a photomask. The technique of film-forming the AlOx film and the technique of the patterning are not limited. The mask 21 is removed by etching in the manufacturing process.

The thickness in a lamination direction of the mask 21 may be in a range of 0.1 µm or more and 10 µm or less.

The semiconductor layer 31 is a layer containing the predetermined semiconductor material that has been epitaxially grown along the mask 21. The n⁻ GaN layer 32 located on the other surface 31a and the n⁺ GaN layer 33 located on the one surface 31b are laminated and included in the semiconductor layer 31. The n⁻ GaN layer 32 is located on the side closer to the surface 21a of the mask 21. The one surface 31b of the semiconductor layer 31 is a surface 33a of the n⁺ GaN layer 33. The n⁺ GaN layer 33 is located on the side farther from the surface 21a of the mask 21, in other words, located on a surface 32a of the n⁻ GaN layer 32.

The concentration of n-type impurities contained in the semiconductor layer 32 is on the order of not greater than 10¹⁶/cm³. The concentration of the n-type impurities contained in the layer of the semiconductor layer 31 on the side closer to the surface 21a of the mask 21 is on the order of not greater than 10¹⁶/cm³. In the present embodiment, the concentration of the n-type impurities contained in the n⁻ GaN layer 32 of the semiconductor layer 31 is on the order of not greater than 10¹⁶/cm³. In the present embodiment, the n-type impurities are Al.

For example, in a case of an element whose withstand voltage is 600 V, the thickness in the lamination direction of the semiconductor layer 31 may be in a range of 2.0 µm or more and 17 µm or less. The thickness in the lamination direction of the n⁻ GaN layer 32 may be larger than the thickness in the lamination direction of the n⁺ GaN layer 33. The thickness in the lamination direction of the n⁻ GaN layer 32 may be in a range of 2.0 µm or more and 12 µm or less. The thickness in the lamination direction of the n⁺ GaN layer 33 may be in a range of 0.1 µm or more and 5 µm or less.

The Schottky electrode 41 is disposed on the other surface 31a of the semiconductor layer 31. The Schottky electrode 41 is formed in a strip shape. An insulating film 42 is an insulating film for making a field plate structure. The insulating film 42 is disposed covering a peripheral edge of the other surface 31a of each semiconductor layer 31 being exposed and a peripheral edge of the Schottky electrode 41. The insulating film 42 is formed in a tubular shape, and has an opening 42a in a center portion. A metal 43 is disposed on a surface 41a of the Schottky electrode 41 exposed from the opening 42a of the insulating film 42 to cover a part of the insulating film 42, thereby constituting the field plate structure. The Schottky electrode 41 is an anode of the semiconductor element 1.

A support substrate 51 supports the one surface 31b of each of the plurality of semiconductor elements 1. The plurality of semiconductor elements 1 supported by the support substrate 51 are connected in parallel or in series. An adhesive layer is formed on one surface 51a of the support substrate 51. An adhesive material having conductivity may be used as appropriate for the adhesive layer. For example, the adhesive layer is made of a nano Ag paste, a nano Cu paste, or high temperature solder. Alternatively, direct bonding may be carried out without using a bonding material. The support substrate 51 may be an n⁺ Si substrate having small electric resistance, for example. The support substrate 51 may be, for example, a compound semiconductor substrate of GaAs, GaP, GaN or the like, or a metal substrate or the like. The one surface 51a of the support substrate 51 and the one surface 31b of the semiconductor layer 31 are attached and bonded in a state of facing each other. The bonding may be carried out under a condition of pressure welding, heating, N2 gas atmosphere, or H2 gas atmosphere, for example.

The ohmic electrode 61 is disposed on the one surface 31b side of the semiconductor layer 31. More specifically, the ohmic electrode 61 is disposed on the other surface 51b of the support substrate 51. The ohmic electrode 61 is a cathode of the semiconductor element 1. When Si is used in the support substrate 51, for example, there are laminated, as an external electrode, aluminum, titanium, nickel, gold, and the like in the order of proximity to the other surface 51b in the ohmic electrode 61.

Next, the manufacturing methods for the semiconductor element 1 and the semiconductor device 2 will be described.

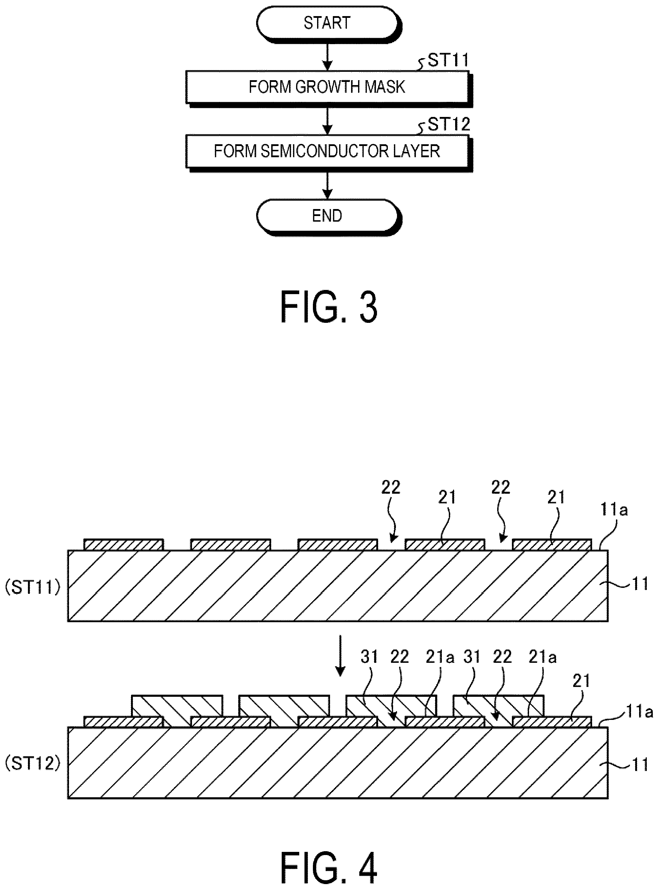

First, the manufacturing method for the semiconductor element 1 will be described with reference to FIGS. 3 and 4. FIG. 3 is a flowchart for describing the manufacturing method for the semiconductor element according to the first embodiment. FIG. 4 is a cross-sectional view for describing the manufacturing method for the semiconductor element according to the first embodiment.

The mask 21, part of which is opened, is formed covering the surface 11a of the base substrate 11 (step ST11). More specifically, an AlOx film is film-formed on the surface 11a of the base substrate 11 by, for example, atomic layer deposition, sputtering, CVD or the like. Then, the AlOx film is patterned by photolithography and etching using a photomask to form the mask 21 having the plurality of openings 22.

In step ST11, a portion of the surface 11a of the base substrate 11 corresponding to the opening 22 of the mask 21 is exposed. In step ST11 in FIG. 4, a diagram is depicted in which the surface 11a located at both ends of the base substrate 11 is not covered with the mask 21. However, the surface 11a located at both the ends of the base substrate 11 may be covered with the mask 21. The entire side surface or back surface of the base substrate 11 may be covered with the mask 21. Of the surfaces that may make contact with a raw material gas used in a vapor phase growth technique described below, the entirety thereof excluding the openings 22 may be covered with the mask 21.

Epitaxial growth is induced along the mask 21 from the surface 11a of the base substrate 11 exposed from the opening 22 of the mask 21 to form the semiconductor layer 31 containing the predetermined semiconductor material (step ST12). More specifically, the semiconductor layer 31 is grown in a (0001) direction and (1120) direction by a vapor phase growth technique using the mask 21, for example, a metal organic chemical vapor deposition (MOCVD) technique or hydride vapour phase epitaxy (HVPE). Specifically, the base substrate 11, on which the mask 21 is formed, is inserted into a reaction tube of an epitaxial apparatus. Then, the base substrate 11 is heated to a predetermined growth temperature, for example, to a temperature in a range of 1050°C or more and 1100°C or less while supplying NH3 as a raw material gas, H2 or N2 or a mixed gas of H2 and N2 as carrier gases, and a group V raw material gas. Once the temperature becomes stable, a group III raw material such as trimethyl gallium (TMG) is supplied in addition to the gases described above, so as to induce vapor phase growth of the semiconductor layer 31 from the opening 22. At this time, a GaN layer of a desired conductivity type may be obtained by supplying a raw material gas of an n-type impurity such as Si, a p-type impurity such as Mg. At this time, the crystal is less likely to grow directly and separately on the surface 21a of the mask 21.

In step ST12, first, the crystal of the predetermined semiconductor material selectively grows on the surface 11a of the base substrate 11 exposed to the opening 22, and continuously grows in a lateral direction along the surface 21a of the mask 21, whereby the semiconductor layer 31 grows on the surface 21a of the mask 21. The growth of the semiconductor layer 31 having grown in the lateral direction is stopped before the semiconductor layer 31 making contact with the adjacent semiconductor layer 31.

In step ST12, the semiconductor layer 31, in order to obtain a desired thickness mainly in the (0001) direction, allows the n⁻ GaN layer 32 to epitaxially grow, and thereafter allows the n⁺ GaN layer 33 to epitaxially grow on the n⁻ GaN layer 32. In the semiconductor layer 31, the n⁻ GaN layer 32 and the n⁺ GaN layer 33 are laminated.

The surface 21a of the mask 21 is formed of a material that does not contain an element to serve as a donor with respect to the semiconductor layer 31, which makes it possible to form the n⁻ GaN layer 32 on the surface 21a. Further, because the surface 21a of the mask 21 is amorphous, it is possible to form the n⁻ GaN layer 32 on the surface 21a.

The base substrate 11, on which the semiconductor layer 31 is formed as described above, is taken out from the epitaxial apparatus.

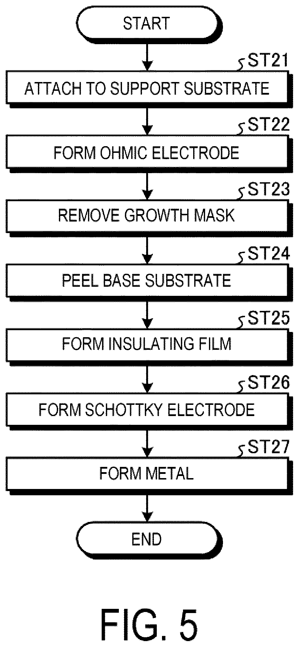

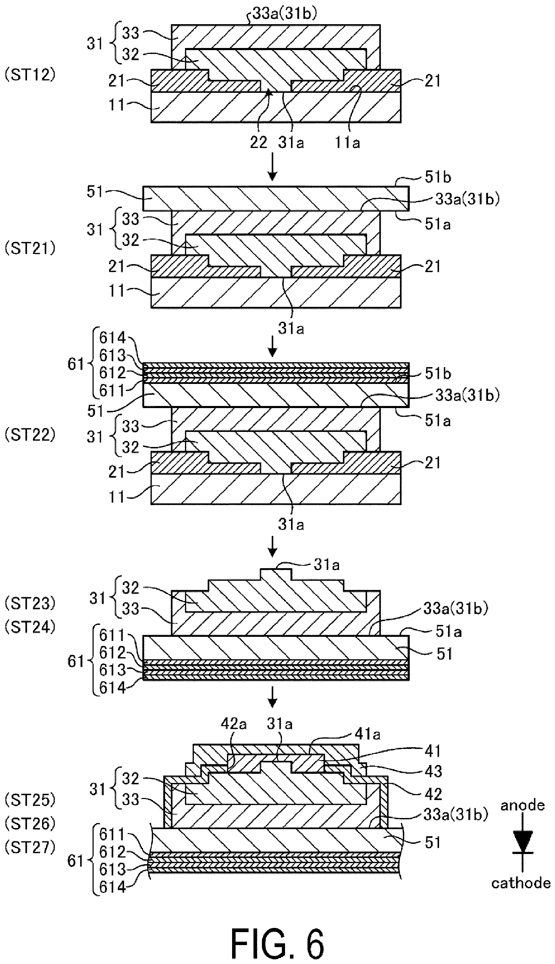

Subsequently, the manufacturing method for the semiconductor device 2 including the semiconductor element 1 will be described with reference to FIGS. 5 and 6. FIG. 5 is a flowchart for describing the manufacturing method for the semiconductor device according to the first embodiment. FIG. 6 includes cross-sectional views for describing the manufacturing method for the semiconductor device according to the first embodiment. Step ST21 to step ST27 are performed after performing step ST11 to step ST12.

The one surface 31b of the semiconductor layer 31 of each of the plurality of semiconductor elements 1 is attached to the support substrate 51 (step ST21). More specifically, the one surface 51a of the support substrate 51 and the one surface 31b of the semiconductor layer 31 are attached and bonded in a state of facing each other. With this, the semiconductor layer 31 of each of the plurality of semiconductor elements 1 is disposed on the one surface 51a of the support substrate 51.

The ohmic electrode 61 is formed on the other surface 51b of the support substrate 51 (step ST22). For example, there are laminated aluminum, titanium, nickel, and gold in the order of proximity to the other surface 51b of the support substrate 51 so as to form the ohmic electrode 61.

Wet etching removes the mask 21 disposed on the base substrate 11 (step ST23).

The base substrate 11 is peeled from the one surface 31b of the semiconductor layer 31 by applying an external force to peel the base substrate 11 and the support substrate 51 from each other (step ST24). The external force is applied, for example, by ultrasonic waves or the like.

The insulating film 42 is formed covering the peripheral edge of the other surface 31a of each strip-shaped semiconductor layers 31 being exposed (step ST25).

The Schottky electrode 41 is formed on the other surface 31a of each semiconductor layer 31 (step ST26).

The metal 43 is formed on the surface 41a of the Schottky electrode 41 exposed from the opening 42a of the insulating film 42 (step ST27).

In this manner, the semiconductor device 2 is formed on the support substrate 51, where the plurality of semiconductor elements 1 are connected in parallel or in series. The semiconductor device 2 is provided with the plurality of semiconductor elements 1 each including the semiconductor layer 31 containing the predetermined semiconductor material, the ohmic electrode 61 disposed on the one surface 31b of the semiconductor layer 31 and the Schottky electrode 41 disposed on the other surface 31a of the semiconductor layer 31, and the support substrate 51 supporting the plurality of semiconductor elements 1. Further, the Schottky electrodes 41 of the semiconductor elements 1 of a plurality of the semiconductor devices 2 may be connected via wires 52.

As described above, because the surface 21a of the mask 21 is made of a material that does not contain an element to serve as a donor with respect to the semiconductor layer 31, the auto-doping is reduced and the n⁻ GaN layer 32 may be formed on the surface 21a. Because the surface 21a of the mask 21 is amorphous, the n⁻ GaN layer 32 may be formed on the surface 21a. As a result of these, after the epitaxial growth of the n⁻ GaN layer 32, the n⁺ GaN layer 33 may be epitaxially grown on the n⁻ GaN layer 32.

With this, because the thickness in the lamination direction of the n⁻GaN layer 32 can be made smaller than the thickness in the lamination direction of the n⁺ GaN layer 33, manufacturing costs and the like involved in the epitaxial growth of the semiconductor element 1 and the semiconductor device 2 may be reduced.

In addition, because the n⁺ GaN layer 33 is epitaxially grown on the n⁻GaN layer 32, device characteristics of the semiconductor element 1 and the semiconductor device 2 may be improved.

The mask 21 is formed of AlOx, and does not include Si that serves as an n-type doping material. This makes it possible to suppress occurrence of auto-doping in which Si of the mask 21 is incorporated into the crystal during the epitaxial growth. As a result of these, the semiconductor element 1 to be manufactured may achieve a low concentration on the order of not greater than 10¹⁶/cm³, which is necessary for a high withstand voltage layer of a power device, for example.

### Second Embodiment

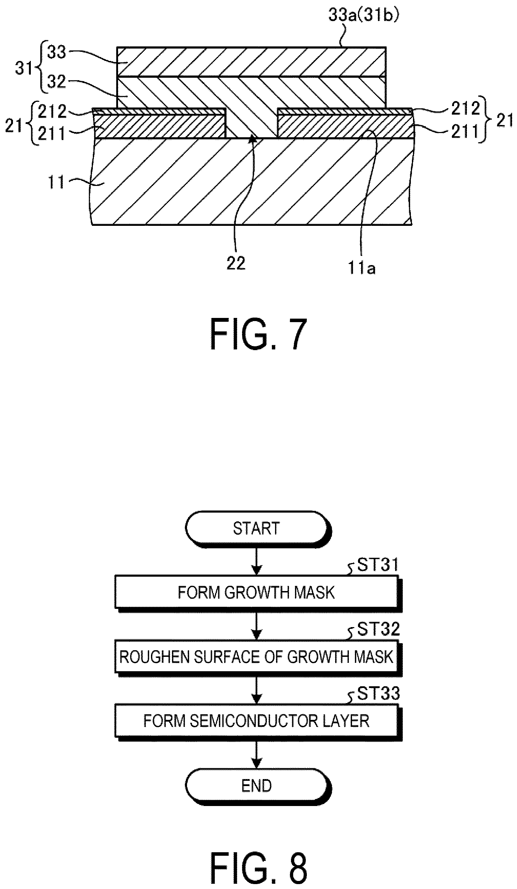

A semiconductor element 1, a semiconductor device 2, and a manufacturing method for the semiconductor element 1 according to an embodiment will be described with reference to FIG. 7. FIG. 7 is a cross-sectional view for describing a manufacturing method for a semiconductor element according to a second embodiment. The basic configurations of the semiconductor element 1, the semiconductor device 2, and the manufacturing method for the semiconductor element 1 are similar to those of the semiconductor element 1, the semiconductor device 2, and the manufacturing method for the semiconductor element 1 according to the first embodiment. In the following description, constituent elements similar to those of the first embodiment are denoted by the same reference signs or corresponding signs, and detailed description thereof will be omitted.

A mask 21 includes a first layer 211 and a plurality of layers having a second layer 212 located on the side closer to a semiconductor layer 31 than the first layer 211. In the present embodiment, the mask 21 includes two layers: the first layer 211 and the second layer 212. The first layer 211 is formed of a second material containing an element to serve as a donor or an acceptor in a predetermined semiconductor material. The first layer 211 is formed of, for example, amorphous SiO₂. The second layer 212 is formed of a first material that does not contain an element to serve as a donor or an acceptor in the predetermined semiconductor material. The second layer 212 is formed of, for example, AlOx. The thickness in a lamination direction of the second layer 212 may be larger than the thickness in a lamination direction of the first layer 211. The thickness in the lamination direction of the first layer 211 may be in a range of 0.5 µm or more and 10 µm or more. The thickness in the lamination direction of the second layer 212 may be in a range of 10 µm or more and 30 µm or less.

As described above, the mask 21 may thin the thickness in the lamination direction of the first layer 211 formed of AlOx. This makes it possible to shorten the time required by the process to form the mask 21 (step ST11). Manufacturing costs of the semiconductor element 1 and the semiconductor device 2 may be reduced.

### Third Embodiment

A semiconductor element 1, a semiconductor device 2, and a manufacturing method for the semiconductor element 1 according to an embodiment will be described with reference to FIG. 8. FIG. 8 is a flowchart for describing a manufacturing method for a semiconductor element according to a third embodiment. Step ST31 and step ST33 are similar to step ST11 and step ST12 illustrated in FIG. 3.

The surface 21a on the side closer to the semiconductor layer 31 in the mask 21 is formed with surface roughness being rough. In step ST31, the surface 21a smoothly formed may be processed to obtain rough surface roughness. In step ST31, the surface 21a formed with the surface roughness being rough may be used as it is. Here, a case in which the surface 21a smoothly formed is processed to obtain rough surface roughness will be described.

The surface 21a on the side closer to the semiconductor layer 31 in the mask 21 having been formed in step ST31 is processed to obtain rough surface roughness (step ST32).

The surface roughness of the surface 21a of the mask 21 is rough, which inhibits the growth of the crystal during the epitaxial growth.

As described above, the surface roughness of the surface 21a on the side closer to the semiconductor layer 31 is rough, so that the crystal may be appropriately grown during the epitaxial growth.

### Fourth Embodiment

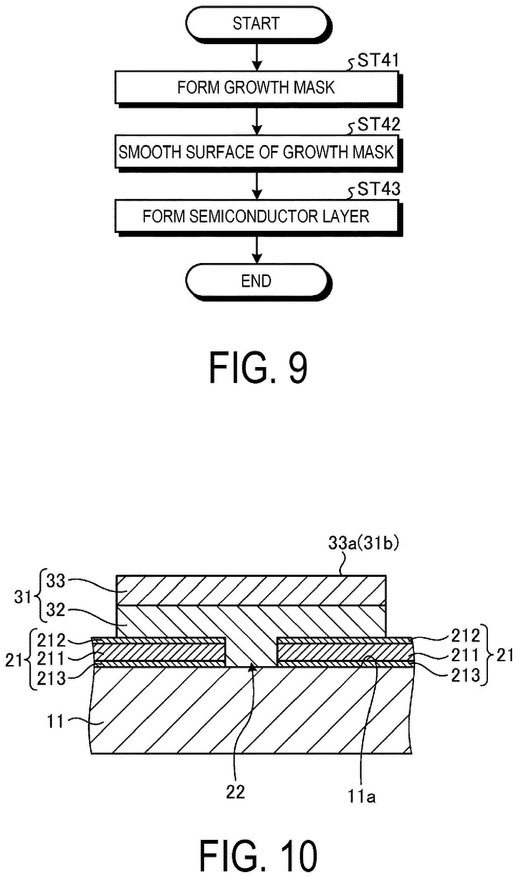

A semiconductor element 1, a semiconductor device 2, and a manufacturing method for the semiconductor element 1 according to an embodiment will be described with reference to FIG. 9. FIG. 9 is a flowchart for describing a manufacturing method for a semiconductor element according to a fourth embodiment. Step ST41 and step ST43 are similar to step ST11 and step ST12 illustrated in FIG. 3.

The surface 21a on the side closer to the semiconductor layer 31 in the mask 21 is formed to have high smoothness. In step ST41, the surface 21a formed smooth may be used as is. In step ST41, the surface 21a formed with the surface roughness being rough may be polished to obtain smoothness. Here, a case in which the surface 21a formed with the surface roughness being rough is polished to obtain high smoothness will be described.

The surface 21a on the side closer to the semiconductor layer 31 in the mask 21 having been formed in step ST41 is polished to obtain high smoothness (step ST42).

By increasing the smoothness of the surface 21a of the mask 21, the raw material gas and the like flow smoothly along the surface 21a during the epitaxial growth.

As described above, by increasing the smoothness of the surface 21a on the side closer to the semiconductor layer 31, the crystal may be appropriately grown during the epitaxial growth.

### Fifth Embodiment

A semiconductor element 1, a semiconductor device 2, and a manufacturing method for the semiconductor element 1 according to an embodiment will be described with reference to FIG. 10. FIG. 10 is a cross-sectional view for describing a manufacturing method for a semiconductor element according to a fifth embodiment.

A mask 21 includes a first layer 211, a second layer 212 located on the side closer to the semiconductor layer 31 than the first layer 211, and a plurality of layers having a third layer 213 located on the side closer to a surface 11a of a base substrate 11 than the second layer 212. In the present embodiment, the mask 21 has three layers: the first layer 211, the second layer 212, and the third layer 213.

The first layer 211 is formed of an amorphous first material containing an element to serve as a donor or an acceptor in a predetermined semiconductor material. The first layer 211 is formed of, for example, amorphous SiO₂. The second layer 212 is formed of the amorphous first material that does not contain an element to serve as a donor or an acceptor in the predetermined semiconductor material. The second layer 212 is formed of, for example, AlOx. The third layer 213 is formed of an amorphous third material that does not contain an element to serve as a donor or an acceptor in the predetermined semiconductor material. The first layer 211 is formed of, for example, AlOx.

As described above, the third layer 213 does not serve as a donor with respect to the base substrate 11, and may suppress occurrence of auto-doping with respect to the base substrate 11. This allows the base substrate 11 to be easily reused in the manufacturing process of other semiconductor elements 1.

The embodiments disclosed by the present application can be modified without departing from the main point or the scope of the present invention. In addition, the embodiments disclosed by the present application and modified examples thereof can be combined as appropriate.

For example, the embodiments disclosed by the present application may be applied to various light emitting elements.

Embodiments have been described in order to fully and clearly disclose the technology according to the appended claims. However, the appended claims are not to be limited to the embodiments described above, and should be configured to embody all modifications and alternative configurations that those skilled in the art may make within the underlying matter set forth herein.

### Reference Signs List

1 Semiconductor element
2 Semiconductor device
11 Base substrate (substrate)
11a Surface
21 Mask
21a Surface
22 Opening
31 Semiconductor layer
31a Other surface
31b One surface
32 n⁻ GaN layer
32a Surface
33 n⁺ GaN layer
33a Surface
41 Schottky electrode (second electrode)
41a Surface
42 Insulating film
43 Metal
43a Surface
51 Support substrate
51a Surface
61 Ohmic electrode (first electrode)

## Claims

1. A manufacturing method for a semiconductor element, the method comprising:
forming a mask partly comprising an opening and configured to cover a surface of a substrate; and
forming a semiconductor layer comprising a predetermined semiconductor material by inducing epitaxial growth along the mask from the surface of the substrate exposed from the opening, wherein
a surface on a side closer to the semiconductor layer in the mask is formed of a first material being amorphous that does not comprise an element to serve as a donor or an acceptor in the predetermined semiconductor material.

2. The manufacturing method for the semiconductor element according to claim 1, wherein
the semiconductor material is GaN, and the first material is aluminum oxide.

3. The manufacturing method for the semiconductor element according to claim 1 or 2, wherein
surface roughness of the surface on the side closer to the semiconductor layer in the mask is rough.

4. The manufacturing method for the semiconductor element according to claim 1 or 2, wherein
smoothness of the surface on the side closer to the semiconductor layer in the mask is high.

5. The manufacturing method for the semiconductor element according to any one of claims 1 to 4, wherein
the mask comprises a first layer, and a plurality of layers comprising a second layer located on a side closer to the semiconductor layer than the first layer,
the first layer is formed of a second material comprising an element to serve as a donor or an acceptor in the predetermined semiconductor material, and
the second layer is formed of the first material.

6. The manufacturing method for the semiconductor element according to any one of claims 1 to 5, further comprising:
in the forming of the semiconductor layer, epitaxially growing an n⁺ GaN layer after epitaxially growing an n⁻ GaN layer, and laminating the n⁻ GaN layer and the n⁺ GaN layer.

7. The manufacturing method for the semiconductor element according to claim 6, wherein
an n-type impurity concentration in the n⁻ GaN layer is on an order of not greater than 10¹⁶/cm³.

8. The manufacturing method for the semiconductor element according to claim 5, wherein
the semiconductor material is GaN,
the mask further comprises a third layer located on a side closer to the surface of the substrate than the first layer, and
the third layer is formed of a third material that does not comprise an element to serve as a donor or an acceptor in the predetermined semiconductor material.

9. A semiconductor device, comprising:
a plurality of semiconductor elements each comprising,
a semiconductor layer comprising a predetermined semiconductor material, and
a first electrode disposed on one surface of the semiconductor layer; and
a support substrate configured to support the one surface of the semiconductor layer of each of the plurality of semiconductor elements,
wherein, in the semiconductor layer, there are laminated an n⁻ GaN layer located on the other surface and an n⁺ GaN layer located on one surface.
